# EUROPÄISCHE PATENTSCHRIFT

(11) **EP 1 014 077 B1**
(45) Veröffentlichungstag und Bekanntmachung des Hinweises auf die Patenterteilung: **03.03.2004**
(21) Anmeldenummer: 99121800.9
(22) Anmeldetag: 02.11.1999
(51) Int. Cl.: G01N 23/20, G01N 23/203

(54) **Verfahren zur Gefügeanalyse an polykristallinen Festkörperproben**
Method of determining the structure of polycristaline solid samples
Méthode d' analyse de la structure d' échantillons solides polycristalins

(30) Priorität: 24.12.1998 DE 19859906
(43) Veröffentlichungstag der Anmeldung: 28.06.2000
(73) Patentinhaber: Leibniz-Institut für Festkörper- und Werkstoffforschung Dresden e.V., 01069 Dresden (DE)
(72) Erfinder: Menzel, Siegfried, 04924 Lausitz (DE); Buerke, Axel, 01099 Dresden (DE); Wetzig, Klaus, 01259 Dresden (DE); Rossek, Uwe, 12489 Berlin (DE)
(74) Vertreter: Rauschenbach, Dieter, Dipl.-Ing. (FH)

(56) Entgegenhaltungen:
- US-A- 5 466 934
- WRIGHT S I: "A REVIEW OF AUTOMATED ORIENTATION IMAGING MICROSCOPY (OIM)" JOURNAL OF COMPUTER-ASSISTED MICROSCOPY, PLENUM PRESS, NEW YORK, NY, US, Bd. 5, Nr. 3, 1993, Seiten 207-221, XP001058918 ISSN: 1040-7286
- ADAMS B L ET AL: "ORIENTATION IMAGING MICROSCOPY: NEW POSSIBILITIES FOR MICROSTRUCTURAL INVESTIGATIONS USING AUTOMATED BKD ANALYSIS" MATERIALS SCIENCE FORUM, AEDERMANNSFDORF, CH, Bd. 157-162, 1994, Seiten 31-42, XP001058310 ISSN: 0255-5476

## Beschreibung

Die Erfindung betrifft ein Verfahren zur Gefügeanalyse an polykristallinen Festkörperproben unter Anwendung der Kikuchi-Technik.

Für die ortsaufgelöste Messung der Kornorientierung in einem Mehrstoffgefüge wird neben dem Verfahren der Mikro-Kosseltechnik sehr vorteilhaft die Kikuchi-Technik eingesetzt. Hierzu werden Primärelektronen (PE) im Rasterelektronenmikroskop auf eine etwa 70° geneigte Probenoberfläche geschossen, und die in oberflächennahen Bereichen quasielastisch gestreuten PE werden an den Atomen der Netzebenen eines Einkristalls gebeugt. Man erhält sogenannte Kikuchi-Patterns, die Informationen über Kristallorientierung, Gitterparameter, Realstruktur, Kristalltyp von einkristallinen Proben liefern. Diese Informationen können auch an Einzelkörnern von polykristallinen Proben gewonnen werden, wenn der Durchmesser der Primärelektronenstrahlung an der Probenoberfläche merklich kleiner als die Korngröße ist. Die Ortsauflösung liegt wegen des hohen erforderlichen Strahlstroms, das heißt für ein gutes Signal-Rausch-Verhältnis, typisch bei etwa 0,5 µm und ist abhängig vom Gittertyp bzw. von den Ordnungszahlen der Elemente in der Probe.

Das besondere Interesse an derartigen Orientierungsmessungen an polykristallinen Werkstoffen besteht darin, nicht nur die Orientierung eines Einzelkorns, sondern die Orientierung der Gesamtheit der Körner in einem Oberflächenbereich zu bestimmen, woraus sich Aussagen über die Orientierungsverteilung im untersuchten Probenabschnitt (Textur) und eine Korrelation zu physikalischen Eigenschaften ableiten lassen. Für ein derartiges Orientierungsmapping muß, im Gegensatz zur Einzelkornorientierungsmessung, der Primärelektronenstrahl des Rasterelektronenmikroskops um eine bestimmte Distanz entlang der Probenoberfläche verschoben bzw. ausgelenkt werden, wodurch die Oberfläche punktweise abgerastert wird.

Bei den bekannten automatischen Verfahren, wie z.B. in US-A-5 466 934 offenbart, wird dabei der Primärstrahl in einem bestimmten Zeittakt um einen bestimmten, wählbaren, aber innerhalb der Messung konstanten Wert α bzw. a ausgelenkt, das heißt nach der Messung in einem Punkt A wird er um a verschoben, und anschließend erfolgt die Messung in einem Punkt B. In der US-A-5 466 934 wird dabei auf einem durch die Auslenkung α bzw. α vorgegebenen Raster die Orientierung der körner an der Oberfläche der Festkörperprobe mit Hilfe der Kikuchi-Technik ermittelt. Da die Größe der Körner innerhalb eines polykristallinen Gefüges unter Umständen sehr unterschiedlich sein kann, erfolgt die Orientierungsmessung im allgemeinen immer an einer anderen Stelle der Körner.

Somit wird bei einer flächenhaften Orientierungsmessung durch punktweise Abrasterung der Probenoberfläche ständig die Elektronenbeugung an einer anderen Stelle der Körner vorgenommen. Das kann im Grenzbereich zwischen zwei Körnern zu nicht auswertbaren Beugungsbiidern führen. Da sich im allgemeinen an die eigentliche Messung eine Auswerteprozedur anschließt, in der automatisch aus den Einzelmeßwerten die Orientierung berechnet und aus der Gesamtheit der Meßwerte das orientierungsabhängige Gefügebild ermittelt wird, muß die Punktdichte sehr groß bzw. der Abstand a sehr klein gewählt werden.

Die Geschwindigkeit der Abrasterung eines Flächenbereichs ist jedoch begrenzt, da für jeden Meßpunkt innerhalb der Flächenmatrix eine aufwendige Auswertroutine zur Bestimmung der Kristallorientierung durchgeführt werden muß. Mit leistungsfähigen Computern sind Rechenzeiten bis typischerweise 1 s pro Meßpunkt, das heißt ca. 4000-8000 Meßpunkte pro Stunde für Patternaufnahme, Bildbearbeitung und Indizierung erforderlich. Für einen Probenbereich mit etwa 30 000 Meßpunkten sind in der Größenordnung 4-8 h Meßzeit nötig.

Um vernünftige Rechenzeiten für einen bestimmten Gefügebereich, der eine statistisch hinreichende Anzahl von Körnern umfaßt zu erreichen, wird im allgemeinen ein Kompromiss zwischen der Größe des Gefügebereichs und der Zahl der Meßpunkte eingegangen. Im allgemeinen sind dabei auch wiederholte Messungen nötig, wenn die Auswertung der Pattern an Körnern nicht eindeutig ist.

Der Erfindung liegt die Aufgabe zugrunde, ein Verfahren zur Gefügeanalyse an polykristallinen Festkörperproben unter Anwendung der Kikuchi-Technik zu schaffen, mit dem gegenüber dem Stand der Technik die Erzeugung eines Gefügebildes wesentlich schneller und exakter mit Hilfe der üblichen rasterelektronenmikroskopischen Abbildungsverfahren mittels Sekundär- bzw. Rückstreuelektronen möglich ist.

Diese Aufgabe wird nach der Erfindung mit einem Verfahren gelöst, bei dem man
a) in einem Rasterelektronenmikroskop (REM) von der Oberfläche der Festkörperprobe in an sich bekannter Weise ein Gefügebild mit hoher Abbildungstreue beziehungsweise Auflösung aufnimmt,
b) aus dem Gefügebild bildanalytisch die geometrischen Schwerpunkte der Körnerschnittflächen ermittelt und von diesen in bezug auf einen gewählten Koordinatenursprung die zugehörigen Vektoren beziehungsweise Kordinaten im Gefügebild bestimmt und zur Bildung eines Datensatzes heranzieht,
c) den erhaltenen Datensatz zur punktweisen Steuerung der Position des Primärstrahls des REM auf der Oberfläche der Festkörperprobe verwendet und
d) an diesen Positionen des Primärstrahls mit Hilfe der Kikuchi-Technik die Orientierung der Körner an der Oberfläche der Festkörperprobe ermittelt.

Gemäß einer zweckmäßigen Ausgestaltung der Erfindung werden aus dem Gefügebild gemäß a) zusätzliche, im Umgebungsbereich der Flächenschwerpunkte liegende weitere Flächenmesspunkte bildanalytisch bestimmt und deren Vektoren beziehungsweise Koordinaten gemäß b) mit zur Bildung des Datensatzes verwendet.

Vorteilhafterweise wird bei der Aufnahme des Gefügebildes gemäß a) die Oberflächennormale der Festkörperprobe zur Achse des Elektronenstrahls mit einem Einfallswinkel α₁ ≥ 0 ausgerichtet wird und dass bei der Anwendung der Kikuchi-Technik gemäß d) die Oberflächennormale der Festkörperprobe zur Achse des Primärstrahls mit einem Einfallswinkel α₂ > 35°bis α₂ > 70° ausgerichtet wird.

Erfindungsgemäß wird im Falle α₁ ≠ α₂ der gemäß b) erhaltene Datensatz hinsichtlich der durch die Probenneigungsdifferenz verursachten Bildverzerrung mittels rechentechnischer Mittel korrigiert.

Mit dem erfindungsgemäßen Verfahren wird die Zuverlässigkeit und Präzision der Orientierungsmessung durch definierte Wahl der Zahl und Lage der Meßpunkte pro Korn erhöht. Außerdem wird die Meßzeit für die orientierungsabhängige Gefügedarstellung, insbesondere bei grobkörnigen Gefügen, bei gleichzeitig richtiger Abbildung des Gefüges um mindestens eine Größenordnung reduziert, da die Anzahl der Meßpunkte auf ein Optimum beschränkt werden kann. Im günstigsten Fall genügt 1 Meßpunkt pro Korn, sofern dieser an einer optimalen Position, insbesondere im Kornzentrum gewählt wird.

Nachstehend ist die Erfindung an einem Ausführungsbeispiel näher erläutert. Die zugehörige Zeichnung zeigt in schematischer Darstellung ein mittels metallografischer Verfahren und mikroskopischer Abbildung gewonnenes Gefügebild.

Die Probe befindet sich dabei in der gekippten Position für die Kikuchi-Analyse, wobei der Fokus des Primärelektronenstrahls (PE-Strahl) dynamisch der geneigten Probenoberfläche nachgeführt wird. Das Bildfeld enthält an der Probenoberfläche (Schnittfläche) insgesamt 10 Körner. Als Koordinatenursprung wird zum Beispiel die linke obere Ecke definiert, da diese für den Scan des PE-Strahls des REM im allgemeinen der Startpunkt ist. Nunmehr wird mit einem bildanalytischen Verfahren der geometrische Schwerpunkt der Einzelköner bestimmt und in der nachstehenden Tabelle erfasst.

| Kornnummer | Fläche /Pixel² | Schwerpunktlage im Korn | x / Pixel | y / Pixel |
|---|---|---|---|---|
| 1 | 100 | x | 80 | 60 |
| 2 | 400 | x | 180 | 130 |
| 3 | 300 | x | 410 | 90 |
| 4 | 240 | x | 65 | 120 |
| 5 | 280 | x | 82 | 270 |
| 6 | 290 | x | 370 | 250 |
| 7 | 80 | | 500 | 240 |
| 8 | 230 | x | 75 | 460 |
| 9 | 420 | x | 230 | 420 |
| 10 | 280 | x | 460 | 430 |

Neben den x,y-Koordinaten beinhaltet die Tabelle ferner eine Spalte für die Größe der Schnittfläche des Korns sowie eine Spalte, in der mittels Kreuz eingeschrieben wird, ob der Schwerpunkt des jeweiligen Korns im Korn oder wie zum Beispiel im Falle von Korn 7 außerhalb des Korns liegt. Zur Ansteuerung des PE-Strahls werden nur die Zeilen verwendet, bei denen der Kornschwerpunkt (was in der Regel der Fall ist) innerhalb des Korns liegt. Bei der eigentlichen Prozedur der Bestimmung der Einzelkornorientierung mittels Kikuchi-Technik wird nun der PE-Strahl mit Hilfe der erstellten Matrix so angesteuert, dass dieser auf die jeweiligen Kornschwerpunkte ausgelenkt und auf diesem Punkt während der Patternaufnahme für das jeweilige Korn gehalten wird. Eine Reduzierung der Fehlmessungen beziehungsweise Erhöhung der Richtigkeit gelingt dadurch, dass man entsprechend der ermittelten Größe der Kornschnittflächen in der unmittelbaren Umgebung der Kornschwerpunkte in einem Abstand mit dem Radius R und dem Winkel φ weitere Meßpunkte definieren kann, wodurch allerdings die Meßzeit entsprechend erhöht würde.

Im einfachsten Fall der ausschließlichen Messung im jeweiligen Kornschwerpunkt wären für das vorliegende Beispiel 10 Meßpunkte notwendig. Da das Gefügebild bekannt ist und sich eindeutig mit den Meßwerten korrelieren läßt, ist - mit Ausnahme von Fällen, bei denen Abweichungen in der Orientierung innerhalb eines Korn vorliegen - ein Orientierungsmap herstellbar. Will man dagegen - wie bisher üblich - mit Hilfe eines feinen Punktrasters mit einer typischen Auflösung von 512x512 Bildpunkten und der zeitaufwendigen Berechnung der Orientierung in jedem dieser Punkte das Orientierungsmapping mit richtiger Wiedergabe des Gefüges gewinnen, ist ein um Größenordnungen höherer Zeitaufwand erforderlich.

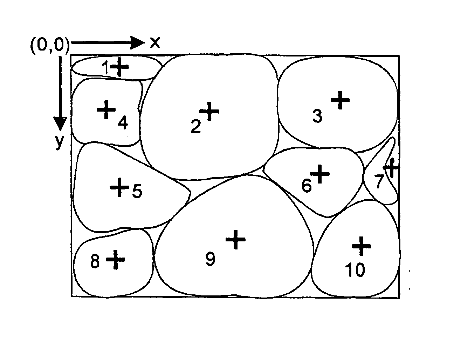

## Patentansprüche

1. Verfahren zur Gefügeanalyse polykristalliner Festkörperproben unter Anwendung der Kikuchi-Technik, wobei man
a) von der Oberfläche einer Festkörperprobe in einem Rasterelektronenmikroskop (REM) ein Gefügebild mit hoher Abbildungstreue beziehungsweise Auflösung aufnimmt,
b) aus dem Gefügebild bildanalytisch die geometrischen Schwerpunkte der Körnerschnittflächen ermittelt und von diesen in bezug auf einen gewählten Koordinatenursprung die zugehörigen Vektoren beziehungsweise Kordinaten im Gefügebild bestimmt und zur Bildung eines Datensatzes heranzieht,
c) den erhaltenen Datensatz zur punktweisen Steuerung der Position des Primärstrahls des REM auf der Oberfläche der Festkörperprobe verwendet und
d) an diesen Positionen des Primärstrahls mit Hilfe der Kikuchi-Technik die Orientierung der Körner an der Oberfläche der Festkörperprobe ermittelt.

2. Verfahren nach Anspruch 1, wobei aus dem Gefügebild gemäß a) zusätzliche, im Umgebungsbereich der Flächenschwerpunkte liegende weitere Flächenmesspunkte bildanalytisch bestimmt und deren Vektoren beziehungsweise Koordinaten gemäß b) mit zur Bildung des Datensatzes verwendet werden.

3. Verfahren nach Anspruch 1, wobei bei der Aufnahme des Gefügebildes gemäß a) die Oberflächennormale der Festkörperprobe zur Achse des Elektronenstrahls mit einem Einfallswinkel α₁ ≥ 0 ausgerichtet wird und dass bei der Anwendung der Kikuchi-Technik gemäß d) die Oberflächennormale der Festkörperprobe zur Achse des Primärstrahls mit einem Einfallswinkel α₂ > 35°bis α₂ > 70° ausgerichtet wird.

4. Verfahren nach Anspruch 1 und 3, wobei im Falle α₁ ≠ α₂ der gemäß b) erhaltene Datensatz hinsichtlich der durch die Probenneigungsdifferenz verursachten Bildverzerrung mittels rechentechnischer Mittel korrigiert wird.

## Claims

1. Method for the structural analysis of polycrystalline solid samples by using the Kikuchi technique, in which
a) a micrograph of the surface of a solid sample is taken with high imaging accuracy or resolution in a scanning electromicroscope (SEM),
b) the geometrical centroids of the grain interfaces are determined from the micrograph by image analysis and are used with reference to a selected origin of coordinates to determine the associated vectors or coordinates in the micrograph, and to form a data record,
c) the data record obtained is used for pointwise control of the position of the primary beam of the SEM on the surface of the solid sample, and
d) the Kikuchi technique is used at these positions of the primary beam to determine the orientation of the grains at the surface of the solid sample.

2. Method according to Claim 1, in which additional further surface measuring points situated in the surroundings of the surface centroids are determined by image analysis from the micrograph in accordance with a), and their vectors or coordinates are used in accordance with b) and also used to form the data record.

3. Method according to Claim 1, in which when taking the micrograph in accordance with a) the surface normal to the solid sample is aligned at an incidence angle of α₁≥ 0 to the axis of the electron beam, and in which when using the Kikuchi technique in accordance with d) the surface normal to the solid sample is aligned at an incidence angle of α₂ > 35° to α₂ > 70° to the axis of the primary beam.

4. Method according to Claims 1 and 3, in which in the case of α₁ ≠ α₂ the data record obtained in accordance with b) is corrected by computing means with regard to the image distortion caused by the difference in sample inclination.

## Revendications

1. Procédé pour l'analyse des réseaux d'échantillons solides polycristallins par recours à la technique de Kikuchi, dans lequel :
a) on saisit au microscope électronique à balayage (REM) une image du réseau à la surface d'un échantillon solide avec une grande fidélité de saisie ou une résolution poussée,
b) par analyse de l'image du réseau, on détermine les barycentres géométriques des interfaces entre grains et à partir d'eux, on définit dans l'image du réseau les vecteurs associés et les coordonnées associées à une origine de coordonnées sélectionnées et on les utilise pour former un jeu de données,
c) on utilise le jeu de données obtenu pour commander point par point la position du faisceau primaire du REM sur la surface de l'échantillon solide et
d) en ces positions du faisceau primaire, on détermine l'orientation des grains à la surface de l'échantillon solide à l'aide de la technique de Kikuchi.

2. Procédé selon la revendication 1, dans lequel, à partir de l'image du réseau de a), on définit par analyse d'image d'autres points supplémentaires de mesure de surface situés au voisinage des barycentres des surfaces et on utilise leurs vecteurs ou coordonnées de b) conjointement pour former le jeu de données.

3. Procédé selon la revendication 1, dans lequel, lors de la saisie de l'image du réseau de a), on oriente la normale à la surface de l'échantillon solide sous un angle d'incidence α₁ ≥ 0 par rapport à l'axe du faisceau d'électrons et dans lequel, lorsque l'on recourt à la technique de Kikuchi de d), on oriente la normale à la surface de l'échantillon solide sous un angle d'incidence α₂ > 35° à α₂ > 70° par rapport à l'axe du faisceau primaire.

4. Procédé selon les revendications 1 et 3, dans lequel, au cas où α₁ ≠ α₂, l'influence de la distorsion de l'image provoquée par la différence d'orientation de l'échantillon sur le jeu de données obtenu en b) est corrigée par des moyens techniques de calcul.
